(19) Europäisches Patentamt / European Patent Office / Office européen des brevets

(11) **EP 3 796 369 B1**

(12) **EUROPEAN PATENT SPECIFICATION**

(45) Date of publication and mention
of the grant of the patent:
**27.03.2024 Bulletin 2024/13**

(21) Application number: **20755206.8**

(22) Date of filing: **23.01.2020**

(51) International Patent Classification (IPC):
**H01L 21/683** *(2006.01)*

(52) Cooperative Patent Classification (CPC):
**H01L 21/67288; H01L 21/6831; H01L 21/68742**

(86) International application number:
**PCT/JP2020/002289**

(87) International publication number:
**WO 2020/166295 (20.08.2020 Gazette 2020/34)**

(54) **METHOD FOR DETECTING ABNORMAL LIFTING AND LOWERING OF SUBSTRATE**

VERFAHREN ZUM ERFASSEN VON ABNORMALEM HEBEN UND SENKEN EINES SUBSTRATS

PROCÉDÉ DE DÉTECTION DE LEVAGE ET D'ABAISSEMENT ANORMAUX D'UN SUBSTRAT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.02.2019 JP 2019022611**

(43) Date of publication of application:
**24.03.2021 Bulletin 2021/12**

(73) Proprietor: **SPP Technologies Co., Ltd.
Tokyo 100-0003 (JP)**

(72) Inventors:
• **SUNABA, Keisuke
Amagasaki-shi, Hyogo 660-0891 (JP)**
• **FUJIWARA, Yuki
Amagasaki-shi, Hyogo 660-0891 (JP)**

(74) Representative: **Grünecker Patent- und
Rechtsanwälte
PartG mbB
Leopoldstraße 4
80802 München (DE)**

(56) References cited:
JP-A- H11 260 897     JP-A- 2004 531 883
JP-A- 2007 165 917     JP-A- 2008 205 313
JP-A- 2014 026 300     JP-A- 2016 157 883
US-A1- 2002 141 133     US-A1- 2008 285 203
US-A1- 2018 240 647

• **AHMAD SUBUTAI ET AL: "Unsupervised
real-time anomaly detection for streaming data",
NEUROCOMPUTING, ELSEVIER, AMSTERDAM,
NL, vol. 262, 2 June 2017 (2017-06-02), pages
134-147, XP085140328, ISSN: 0925-2312, DOI:
10.1016/J.NEUCOM.2017.04.070**

EP 3 796 369 B1

**Description**

[Technical Field]

The present invention relates to an abnormality detection apparatus for detecting lifting abnormality of a substrate in a substrate processing apparatus including a lifting mechanism for lifting a substrate, a substrate processing system including the same, an abnormality detection method, a program, a learning model, and a generation method of a learning model. Particularly, the present invention relates to an abnormality detection apparatus, a substrate processing system, an abnormality detection method, a program, a learning model, and a generation method of a learning model, which are capable of quickly and accurately detecting lifting abnormality of a substrate attributable to detachment failure of a substrate from an electrostatic chuck, or the like.

[Background Art]

Conventionally, as a substrate processing apparatus for processing a substrate, there is known a plasma processing apparatus which performs plasma processing such as etching processing and film deposition processing on a substrate by using plasma.

A plasma processing apparatus generally includes a chamber in which plasma is generated, a mounting table which is disposed in the chamber and on which a substrate is mounted, a lifting mechanism such as a lift pin for lifting a substrate. In general, an electrostatic chuck is provided on the mounting table.

The electrostatic chuck is provided on an upper part of the mounting table and is made of dielectric embedded with an electrode. The substrate is electrostatically attracted to the electrostatic chuck by electrostatic force between the electrode and the substrate generated by applying a DC voltage to the electrode of the electrostatic chuck.

When performing plasma processing on a substrate with a plasma processing apparatus, the substrate is electrostatically attracted to the electrostatic chuck by applying a DC voltage to the electrode of the electrostatic chuck. Then, plasma processing is performed on the electrostatically attracted substrate.

When the plasma processing is finished, the substrate is detached from the electrostatic chuck. Specifically, by stopping application of the DC voltage to the electrode of the electrostatic chuck, electrostatic attraction of the substrate by the electrostatic chuck is stopped. Then, after the substrate is lifted up by the lifting mechanism, the substrate is transferred to the outside of the chamber with a transfer mechanism.

Here, when detaching the substrate from the electrostatic chuck, there is a case in which the substrate is attracted to the electrostatic chuck by electrostatic force remaining in the electrostatic chuck even after stopping the application of the DC voltage, and thereby detachment failure of the substrate occurs. Specifically, pushing up the attracted substrate by the lifting mechanism may cause misalignment of the substrate, or the like, resulting in problems in the transfer of the substrate thereafter. Moreover, when the remaining electrostatic force is large, forcibly pushing up the attracted substrate may lead to damage of the substrate.

Therefore, to avoid transfer failure and damage of the substrate, it is desirable to quickly and accurately detect lifting abnormality (particularly, abnormality when the substrate is lifted up).

Conventionally, as the apparatus for detecting abnormality of operating conditions of a lift pin, there is proposed an apparatus according to Patent Literature 1.

However, the apparatus according to Patent Literature 1 is an apparatus for detecting excessive abnormality such as damage of a lift pin, and is not capable of quickly and accurately detecting lifting abnormality of a substrate attributable to detachment failure of the substrate from an electrostatic chuck, or the like. Other relevant prior art for an abnormal lifting detection system is presented in US2008285203.

Moreover, Patent Literature 2 proposes an apparatus for detecting the attracted state of a substrate by an electrostatic chuck.

However, the apparatus according to Patent Literature 2 is an apparatus for evaluating whether or not the electrostatic chuck attracts the substrate with an appropriate electrostatic force when processing is performed on the substrate, and is not capable of quickly and accurately detect lifting abnormality of the substrate attributable to detachment failure of the substrate from the electrostatic chuck, or the like.

[Citation List]

[Patent Literature]

[Patent Literature 1] JP2010-278271A

[Patent Literature 2] JP2008-277706A

[Summary of Invention]

[Technical Problem]

The present invention has been made to solve problems of the conventional art described above and has its object to provide an abnormality detection apparatus, a substrate processing system, an abnormality detection method, a program, a learning model, and a generation method of a learning model, which are capable of quickly and accurately detecting lifting abnormality of a substrate attributable to detachment failure of a substrate from an electrostatic chuck, or the like.

[Solution to Problem]

To solve the above described problems, the present inventors have conducted diligent study and focused on utilizing time-series measurements of a parameter having a correlation with the load applied to the lifting mechanism during lifting-up of the substrate. This is because the present inventors considered that depending on whether lifting of the substrate is normal or abnormal, the state of temporal change of measurements of the load applied to the lifting mechanism (or measurements of another parameter having a correlation with the load) during lifting-up varies.

However, it is conceivable that difference in temporal change of measurements according to whether or not lifting of the substrate is normal is small. For that reason, when simply comparing the measurements with a threshold and thereby detecting lifting abnormality from a difference therebetween, it is considered to be difficult to decide the threshold and the detection accuracy of lifting abnormality will be poor. It is also conceivable to compare measurements with the threshold at a timing at which difference between measurements when lifting of the substrate is normal and measurements when lifting of the substrate is abnormal becomes large. However, if lifting abnormality is detected at this timing, there is a risk that the timing of stopping the operation of the lifting mechanism may be delayed, and avoidance of transfer failure and damage of the substrate may not be in time. For this reason, as a result of studying application of machine learning to time-series measurements of a parameter having a correlation with the load applied to the lifting mechanism, the present inventors have found that it is possible to quickly and accurately detect lifting abnormality of a substrate.

The present invention has been completed based on the above described findings of the present inventors.

That is, to solve the above described problems, the present invention provides an abnormality detection apparatus for detecting lifting abnormality of a substrate in a substrate processing apparatus including a lifting mechanism for lifting the substrate, comprising: a measurement section configured to measure a parameter having a correlation with load applied to the lifting mechanism; and a detection section configured to detect lifting abnormality of the substrate, wherein the detection section includes a learning model generated by using machine learning, wherein the learning model receives, as input, a plurality of measurements of the parameter continuously measured by the measurement section during lifting-up of the substrate by the lifting mechanism, and outputs a level of lifting abnormality of the substrate.

According to the abnormality detection apparatus relating to the present invention, a parameter having a correlation with the load applied to the lifting mechanism is continuously measured during lifting-up of the substrate by the measurement section, and this plurality of measurements are input to a learning model generated by using the machine learning of the detection section, so that the learning model will output a level of lifting abnormality of the substrate. The detection section can detect lifting abnormality according to the level of lifting abnormality output from the learning model (for example, when the level of lifting abnormality is not less than a predetermined threshold, it is determined that lifting abnormality has occurred).

According to the abnormality detection apparatus relating to the present invention, since it is only necessary to input a plurality of measurements of a parameter having a correlation with the load applied to the lifting mechanism continuously measured by the measurement section to a learning model generated by using machine learning, there will be no difficulty in deciding a threshold like in a case of directly comparing measurements of the parameter with the threshold. Thus, as being found by the present inventors, it is possible to quickly and accurately detect lifting abnormality of a substrate.

Note that the lifting abnormality of a substrate to be detected by the abnormality detection apparatus according to the present invention will not be limited to lifting abnormality of a substrate attributable to detachment failure of a substrate from an electrostatic chuck. It is also possible to detect, for example, abnormality in which a substrate interferes with a member constituting the substrate processing apparatus due to misalignment, etc. in the process of lifting up the substrate by the lifting mechanism included in a transfer robot which operates in the substrate processing apparatus.

Preferably, the learning model is generated by using machine learning such that in the case of receipt of a plurality of measurements of the parameter taken when lifting of the substrate is normal as an input of teaching data, the learning model outputs an indication of normal lifting of the substrate.

According to the above described preferable configuration, the learning model is generated by using machine learning such that in the case of receipt of a plurality of measurements of a parameter taken when lifting of the substrate is normal as an input of teaching data (teaching data is a combination of known input and output to and from the learning model), the learning model outputs an indication (specifically, a numerical value indicating that the level of lifting abnormality is minimum, for example, "0") of normal lifting of the substrate (that is, by giving, for example, "0" as the output of the teaching data).

By generating a learning model by performing machine learning with use of the teaching data as described above, complicated adjustment of threshold, etc., and study of complicated detection logics are obviated so that lifting abnormality of a substrate can be easily detected by only inputting a plurality of measurements of a parameter to the learning model after machine learning.

The abnormality detection apparatus according to the present invention is preferably used for detecting lifting abnormality of a substrate attributable to detachment failure of the substrate from an electrostatic chuck.

That is, preferably, the substrate processing apparatus includes an electrostatic chuck for electrostatically attracting the substrate when processing the substrate, and the detection section detects lifting abnormality of the substrate attributable to detachment failure of the substrate based on a plurality of measurements of the parameter continuously measured by the measurement section during lifting-up of the substrate by the lifting mechanism after stopping electrostatic attraction of the substrate by the electrostatic chuck.

Also, preferably, the lifting mechanism comprises a lift pin which is brought into contact with a rear face of the substrate and lifts the substrate, and a cylinder apparatus which is connected to the lift pin and lifts the lift pin, and wherein the measurement section is a load cell which is attached to a piston rod of the cylinder apparatus and measures load applied to the piston rod.

According to the preferable configuration described above, measurements of the load applied to the piston rod measured by a load cell as the measurement section are input as a parameter to the learning model included in the detection section.

However, the present invention will not be limited to this, and for example, when the cylinder apparatus is an electric cylinder apparatus driven by a motor, it is also possible to adopt a mode in which torque of the motor is measured by a known torque measurement apparatus, and the torque measurements are input as a parameter (a parameter having a correlation with the load applied to the lifting mechanism) to the learning model included in the detection section.

Preferably, the learning model is generated by using machine learning based on a k-nearest neighbor algorithm.

According to the k-nearest neighbor algorithm, it is possible to perform machine learning by using only teaching data when lifting of the substrate is normal.

However, the present invention will not be limited to this, and it is possible to adopt various configurations as long as it is a learning model which can be generated by using machine learning, such as a support vector machine and neural networks (including CNN (Convolutional Neural Network) and RNN (Recurrent Neural Network)).

Preferably, the substrate processing apparatus includes a chamber which is under a vacuum environment when processing the substrate, and an electrostatic chuck for electrostatically attracting the substrate when processing the substrate, the measurement section measures, in addition to the parameter having a correlation with load applied to the lifting mechanism, at least one parameter of a parameter having a correlation with attraction force between the electrostatic chuck and the substrate and a parameter having a correlation with pressure inside the chamber, and the learning model receives, as input, a plurality of measurements of the parameters continuously measured by the measurement section during lifting-up of the substrate by the lifting mechanism, and outputs a level of lifting abnormality of the substrate.

According to the preferable configuration described above, at least one parameter of a parameter having a correlation with attraction force between the electrostatic chuck and the substrate and a parameter having a correlation with pressure inside the chamber is further measured by the measurement section, and in addition to a plurality of measurements of a parameter having a correlation with the load applied to the lifting mechanism, a plurality of measurements of the at least one parameter are input to the learning model so that the learning model outputs a level of lifting abnormality of the substrate. Because of this, compared with a case in which only a parameter having a correlation with the load applied to the lifting mechanism is input, it is expected that lifting abnormality of the substrate can be detected furthermore accurately.

Preferably, the detection section includes an input section configured to input presence or absence of lifting abnormality of the substrate, and stores the presence or absence of lifting abnormality of the substrate input from the input section, in association with a plurality of measurements of the parameter continuously measured by the measurement section, and detection result of lifting abnormality of the substrate by the detection section.

In the preferred configuration described above, the presence or absence of lifting abnormality of the substrate input from the input section is judged by, for example, an operator directly visually observing the inside of the substrate processing apparatus, an operator visually observing a captured image of the inside of the substrate processing apparatus, or an operator confirming the presence or absence of damage of the substrate after processing.

According to the preferable configuration described above, the presence or absence of lifting abnormality of the substrate input from the input section, a plurality of measurements of a parameter continuously measured by the measurement section, and detection result of lifting abnormality of the substrate by the detection section are stored to be linked with the detection section.

Therefore, supposing that the presence or absence of lifting abnormality of the substrate input from the input section is true, it is possible to judge propriety of the detection result of lifting abnormality detected by the detection section by using a plurality of measurements of a parameter continuously measured by the measurement section. When the presence or absence of lifting abnormality of the substrate input from the input section does not agree with the detection result of lifting abnormality detected by the detection section, it is possible to further improve detection accuracy of the detection section by performing relearning of the learning model included in the detection section.

To solve the above described problems, the present invention also provides a substrate processing system, comprising a substrate processing apparatus including a lifting mechanism for lifting a substrate, and the abnormality detection apparatus according to any of the above.

To solve the above described problems, the present invention further provides an abnormality detection method for detecting lifting abnormality of a substrate in a substrate processing apparatus including a lifting mechanism for lifting the substrate, comprising: a measurement step of measuring a parameter having a correlation with load applied to the lifting mechanism; and a detection step of detecting lifting abnormality of the substrate, wherein in the detection step, by using a learning model generated by using machine learning, a plurality of measurements of the parameter continuously measured in the measurement step during lifting-up of the substrate by the lifting mechanism are input to the learning model, and a level of lifting abnormality of the substrate is output from the learning model.

To solve the above described problems, the present invention further provides a program for causing a detection section including the learning model to execute the detection step included in the abnormality detection method.

This program may be recorded in a computer readable recording medium.

To solve the above described problems, the present invention further provides a learning model generated by using machine learning, wherein the learning model receives, as input, a plurality of measurements of a parameter having a correlation with load applied to a lifting mechanism included in a substrate processing apparatus, the plurality of measurements of the parameter being continuously measured during lifting-up of a substrate by the lifting mechanism, and the learning model outputs a level of lifting abnormality of the substrate.

To solve the above described problems, the present invention further provides a generation method of a learning model, wherein the learning model receives, as input, a plurality of measurements of a parameter having a correlation with load applied to a lifting mechanism included in a substrate processing apparatus, the plurality of measurements of the parameter being continuously measured during lifting-up of a substrate by the lifting mechanism, and the learning model outputs a level of lifting abnormality of the substrate, and wherein the learning model is generated by using machine learning such that in the case of receipt of a plurality of measurements of the parameter taken when lifting of the substrate is normal as an input of teaching data, the learning model outputs an indication of normal lifting of the substrate.

[Advantageous Effect of Invention]

According to the present invention, it is possible to quickly and accurately detect lifting abnormality of a substrate attributable to detachment failure of the substrate from an electrostatic chuck, or the like.

[Brief Description of Drawings]

[Fig. 1] Figs. 1A and 1B are schematic diagrams for showing an outline configuration of a substrate processing system according to a first embodiment of the present invention.
[Fig. 2] Fig. 2 is a functional block diagram of a detection section shown in Fig 1.
[Fig. 3] Figs. 3A, 3B, and 3C are explanatory diagrams for illustrating load measurements measured by a measurement section included in an abnormality detection apparatus shown in Fig. 1.
[Fig. 4] Fig. 4 is a diagram for showing an example of load measurements measured by the measurement section shown in Fig. 1.
[Fig. 5] Figs. 5A and 5B are diagrams for showing an example of test result using the abnormality detection apparatus according to the first embodiment.
[Fig. 6] Figs. 6A, 6B, and 6C are diagrams for showing an example of test result using the abnormality detection apparatus according to the second embodiment.

[Description of Embodiments]

Hereinafter, referring to the appended drawings, an abnormality detection apparatus according to embodiments of the present invention, and a substrate processing system including the same will be described.

<First embodiment>

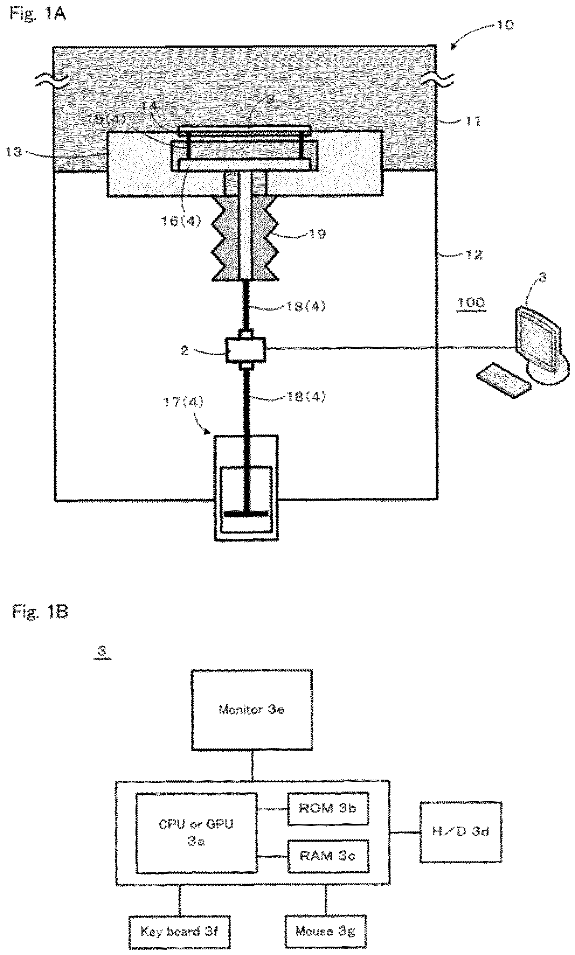

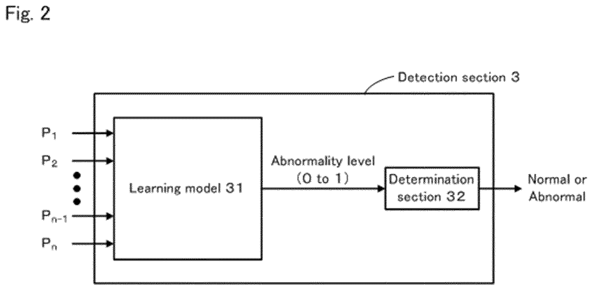

Figs. 1A and 1B are schematic diagrams for showing an outline configuration of a substrate processing system according to a first embodiment of the present invention. Fig. 1A is a diagram for showing a general configuration of the substrate processing system, and Fig. 1B is a block diagram for showing an outline configuration of a detection section included in an abnormality detection apparatus of the substrate processing system. Fig. 2 is a functional block diagram of the detection section shown in Figs. 1A and 1B. In Fig. 1A, a substrate processing apparatus of the substrate processing system is illustrated in a cross section.

As shown in Fig. 1A, the substrate processing system according to the first embodiment includes a substrate processing apparatus 10 and an abnormality detection apparatus 100.

The substrate processing apparatus 10 of the first embodiment is a plasma processing apparatus, and includes a chamber 11 and a housing 12 provided under the chamber 11. The inside of the chamber 11 is kept in a vacuum environment when performing processing on a substrate S, and the inside of the housing 12 is always kept in an atmospheric environment.

The substrate processing apparatus 10 includes a mounting table 13 which is disposed within the chamber 11 and on which the substrate S is mounted, an electrostatic chuck 14 which is provided in the upper part of the mounting table 13 and electrostatically attracts the substrate S when processing the substrate S, and a lifting mechanism 4 for lifting the substrate S. The lifting mechanism 4 of the first embodiment includes a plurality of lift pins 15 which is in contact with a rear face of the substrate S and lifts the substrate S, a lifting body (a member illustrated in a T shape in Fig. 1A) 16 which is connected to the lower end of the plurality of lift pins 15 and lifts the plurality of lift pins 15 concurrently, and a cylinder apparatus (air cylinder apparatus in the first embodiment) 17 which is connected to the lower end of the lifting body 16 and lifts the lifting body 16.

Note that the mounting table 13 has a cavity sectioned by an inner wall, and an upper portion (area of a T shape extending horizontally) of the lifting body 16 is accommodated in the cavity. Moreover, the lifting body 16 is attached to a piston rod 18 of the cylinder apparatus 17. Further, a lower part (area that protrudes below the mounting table 13) of the lifting body 16 is covered with bellows 19.

When the substrate S is processed, a DC voltage is applied to an electrode (not shown) of the electrostatic chuck 14 and the substrate S is electrostatically attracted to the electrostatic chuck 14. Then, in this state, processing gas for generating plasma is supplied into the chamber 11 from a gas source (not shown).

When the substrate processing apparatus 10 is a plasma processing apparatus of an inductively coupled plasma (ICP) type, a coil (not shown) is disposed to surround the chamber 11, and the processing gas supplied in the chamber 11 is turned into plasma by applying high-frequency power to the coil.

When the substrate processing apparatus 10 is a plasma processing apparatus of capacitively coupled plasma (CCP) type, an electrode (not shown) is disposed in parallel with the mounting table 13 in the chamber 11, and processing gas supplied to the chamber 11 is turned into plasma by applying high-frequency power to the electrode.

With the plasma generated in the chamber 11 as described above, plasma processing such as etching processing and film deposition processing is performed on the substrate S.

After the plasma processing is finished, electrostatic attraction of the substrate by the electrostatic chuck 14 is stopped by stopping the application of a DC voltage to the electrode of the electrostatic chuck 14. Then after the substrate S is lifted up by the lifting mechanism 4, the substrate S is transferred to the outside of the chamber 11 by a transfer mechanism (not shown).

The abnormality detection apparatus 100 is an apparatus for detecting lifting abnormality of the substrate S in the substrate processing apparatus 10 having the above described configuration. The abnormality detection apparatus 100 according to the first embodiment is an apparatus for detecting lifting abnormality of a substrate S attributable to detachment failure of the substrate S during lifting-up of the substrate S by the lifting mechanism 4 after the electrostatic attraction of the substrate S by the electrostatic chuck 14 is stopped.

The abnormality detection apparatus 100 includes a measurement section 2 for measuring a parameter having a correlation with load applied to the lifting mechanism 4, and a detection section 3 for detecting lifting abnormality of the substrate S.

The measurement section 2 of the first embodiment measures load itself as a parameter having a correlation with the load applied to the lifting mechanism 4. In the first embodiment, as the measurement section 2, a load cell is used, which is attached to the piston rod 18 of the cylinder apparatus 17 and measures the load applied to the piston rod 18. Specifically, the piston rod 18 is divided into an upper part and a lower part, and the load cell as the measurement section 2 is attached between them in an interposed manner. Thus, tensile load or compressive load will be applied to the measurement section 2 from both the upper part and the lower part of the divided piston rod 18. Because of this, the measurement section 2 is capable of measuring load (load in the vertical direction) applied to the piston rod 18.

The detection section 3 is electrically connected to the measurement section 2, and is constituted by, for example, a computer.

As shown in Fig. 1B, the detection section 3 of the first embodiment includes, like a configuration included in a common computer, a computer main body including a CPU or GPU 3a, a ROM 3b and a RAM 3c, and a hard disk (HID) 3d, a monitor 3e, a key board 3f, and a mouse 3g connected to the computer body. As shown in Fig. 2, the detection section 3 of the first embodiment includes, from a functional view point, a learning model (also referred to as a classifier) 31 generated by using machine learning and a determination section 32. The learning model 31 and the determination section 32 are each constituted by, for example, a memory such as the ROM 3b and the RAM 3c included in a computer, and a program which is stored in the memory and causes the CPU or GPU 3a to execute operation as the learning model 31 and the determination section 32.

Note that as the detection section 3, it is also possible to use a cloud server and an edge server, which are remotely disposed from the substrate processing apparatus 10, without being limited to a computer close to the substrate processing apparatus 10.

The learning model 31 included in the detection section 3 of the first embodiment receives, as input, a plurality of load measurements continuously measured by the measurement section 2 during lifting-up of the substrate S by the lifting mechanism 4.

Specifically, as shown in Fig. 2 a plurality of (n, for example, n = 5) load measurements $P_1$ to $P_n$ which are measured at each predetermined sampling period (for example, 100 msec) by the measurement section 2 are input to the learning model 31. The learning model 31 outputs a level of lifting abnormality (hereinafter, appropriately referred to as an abnormality level) of the substrate S based on the input plurality of load measurements $P_1$ to $P_n$. In other words, the abnormality level at the time point of measuring the load measurement $P_n$ is output. Next, though illustration is omitted, a plurality of load measurements $P_2$ to $P_{n+1}$ which are measured with a deviation of one sampling period are input to the learning model 31. The learning model 31 outputs an abnormality level at the time point of measuring the load measurement $P_{n+1}$ based on the input plurality of load measurements $P_2$ to $P_{n+1}$. Next, a plurality of load measurements $P_3$ to $P_{n+2}$ which are measured with a further deviation of one sampling period are input to the learning model 31. The learning model 31 outputs an abnormality level at the time point of measuring the load measurement $P_{n+2}$ based on the input plurality of load measurements $P_3$ to $P_{n+2}$. Hereinafter, by repeating the above described operation, an abnormality level will be output from the learning model 31 at each sampling period. The abnormality level to be output from the learning model 31 of the first embodiment is set to be a value of 0 to 1, in which the higher the level of lifting abnormality is, the larger the value is.

The learning model 31 of the first embodiment is generated by machine learning with use of a k-nearest neighbor algorithm. Since the k-nearest neighbor algorithm used in the first embodiment is the same as in a known content, detailed description thereof will be omitted.

Specifically, at the time of learning of the learning model 31, a plurality (n, for example, n = 5) of load measurements when lifting of the substrate S is normal are given as an input of the teaching data, and as the output of the teaching data to be combined with the aforementioned input, an indication of normal lifting of the substrate S (the abnormality level = 0 in the first embodiment) is given, so that machine learning with use of the k-nearest neighbor algorithm is performed such that when the aforementioned input is input to the learning model 31, an abnormality level = 0 will be output from the learning model 31. As the input of the above described teaching data, as with the aforementioned load measurements $P_1$ to $P_n$, load measurements $P_2$ to $P_{n+1}$, load measurements $P_3$ to $P_{n+2}$, and the like, a plurality of load measurements which are measured with a deviation of one sampling period are used, and an abnormality level = 0 is given as output for any input.

Note that machine learning of the learning model 31 will not be limited to once. As needed, it is also possible to perform relearning of the learning model 31 by using new teaching data, or perform relearning of the learning model 31 by adding new teaching data to past teaching data.

At the time of detection in which lifting abnormality of the substrate S is detected based on the plurality of load measurements, which are sequentially input, by the learning model 31 having been subjected to learning as described above, a plurality of load measurements are sequentially input to the learning model 31, and the abnormality level will be sequentially output from the learning model 31. In contrast to the time of learning, the value of abnormality level to be output at the time of detection will be $0 \leq$ abnormality level $\leq 1$.

The determination section 32 of the first embodiment receives, as an input, the abnormality level output from the learning model 31. The determination section 32 detects lifting abnormality of the substrate S (determines that lifting abnormality has occurred) according to the input abnormality level. Specifically, a threshold Th is set in advance in the determination section 32. Then, the determination section 32 determines that lifting of the substrate S is normal if the abnormality level is less than the threshold Th, and that lifting abnormality of the substrate S has occurred if the abnormality level is not less than the threshold. As described above, since output of the abnormality level by the learning model 31 is performed at each sampling period of the load measurement, the determination by the determination section 32 is performed at each sampling period of the load measurement as well.

Note that the present embodiment is configured, as a preferable mode, such that the abnormality level to be output from the learning model 31 and the result of determination at the determination section 32 are displayed on a monitor 3e included in the detection section 3. Moreover, when it is determined that lifting abnormality of the substrate S has occurred at the determination section 32, it is configured such that alarm sound is issued from a speaker (not shown) included in the detection section 3. When an operator visually recognizes such display of the monitor 3e, or when an operator hears the alarm sound, it is also possible that the operator forcibly stops the operation of the lifting mechanism 4.

Moreover, the present embodiment is configured, as a preferable mode, such that the detection section 3 stores the presence or absence of lifting abnormality of the substrate S input from the input section (key board 3f, mouse 3g, etc.) linked with a plurality of load measurements continuously measured by the measurement section 2 and detection results of lifting abnormality of the substrate S by the detection section 3 (the abnormality level output from the learning model 31, and the result by the determination section 32) in the hard disk 3d. The presence or absence of lifting abnormality of the substrate S input from the input section is judged by an operator visually observing the inside of the substrate processing apparatus 10 directly, by an operator visually observing a captured image of the inside of the substrate processing apparatus 10, or by an operator confirming the presence or absence of damage of the substrate S after processing. Supposing that the presence or absence of lifting abnormality of the substrate S input from the input section is true, it is possible to judge propriety of the detection result of lifting abnormality detected by the detection section 3 by using a plurality of load measurements continuously measured by the measurement section 2. When the presence or absence of lifting abnormality of the substrate input from the input section does not agree with the detection result of lifting abnormality detected by the detection section 3, it is possible to further improve detection accuracy of the detection section 3 by performing relearning of the learning model 31 included in the detection section 3, or by reconsidering the threshold Th to be set for the determination section 32.

Hereinafter, load measurements to be measured by the measurement section 2 will be described more specifically.

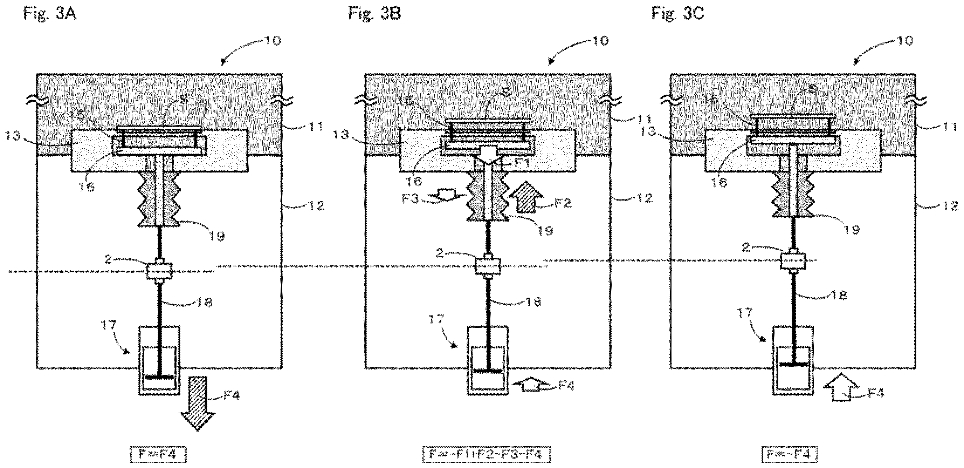

Figs. 3A, 3B, and 3C are explanatory diagrams for illustrating load measurements to be measured by the measurement section 2 included in the abnormality detection apparatus 100 according to the first embodiment. Fig. 3A shows a state (a state immediately after the processing of the substrate S is finished) in which a lift pin 15 is located at a lower limit position, Fig. 3B shows a state in which the lift pin 15 is being lifted up, and Fig. 3C shows a state in which the lift pin 15 is located at an upper limit position. Note that, in Figs. 3A, 3B and 3C, an arrow filled in white means compressive load applied to the measurement section 2, and an arrow hatched with diagonal lines means the tensile load applied to the measurement section 2. Moreover, the length of each arrow means the magnitude (absolute value) of load.

In a state shown in Fig. 3A, the lifting body 16, whose upper part is in contact with the lower surface of the inner wall of the mounting table 13, is pulled downward by the cylinder apparatus 17. In this state, since the lifting body 16 stands still by being supported by the lower surface of the inner wall of the mounting table 13, the resultant force of the load applied to the lifting body 16 is balanced. For this reason, fluctuating load F4 (tensile load in the state shown in Fig. 3A) corresponding to a thrust force with which the cylinder apparatus 17 pulls the lifting body 16 downward is applied to the measurement section (load cell) 2. In the state shown in Fig. 3A, the magnitude of the fluctuating load F4 is about 150 N at maximum.

That is, in the state shown in Fig. 3A, letting a load measurement measured by the measurement section 2 be F, and the magnitude (absolute value) of the fluctuating load F4 be F4, the load measurement F is expressed by the following formula.

$$F = F4$$

In the state shown in Fig. 3B, a fixed compressive load F1 substantially corresponding to a total sum of weights of the substrate S, the lift pin 15, the lifting body 16, and an upper portion of the piston rod 18 is applied to the measurement section 2. Moreover, since the inside of the chamber 11 is a vacuum environment, and the inside of the housing 12 is an atmospheric environment, fixed tensile load F2 generated by this pressure difference is applied to the measurement section 2. Moreover, since the bellows 19 contracts according to the lifting-up of the lift pin 15 (lifting-up of the lifting body 16), compressive load F3 corresponding to expanding force of the bellows 19 is applied to the measurement section 2. This compressive load F3 is fluctuating load which depends on expansion and contraction of the bellows 19. Further, fluctuating load F4 (compressive load in the state shown in Fig. 3B) corresponding to a thrust force with which the cylinder apparatus 17 pushes up the lifting body 16 upward is applied to the measurement section 2. Then, when supposed that the sign of compressive load and the sign of tensile load are different (for example, the sign of tensile load is positive and the sign of compressive load is negative), a total sum of compressive loads F1, F3, and F4 and tensile load F2 will be measured by the measurement section 2 as a load measurement.

That is, in the state shown in Fig. 3B, supposing that the load measurement measured by the measurement section 2 is F, and the magnitudes (absolute values) of each load F1 to F4 are F1 to F4, the load measurement F is expressed by the following formula.

$$F = -F1 + F2 - F3 - F4$$

In the state shown in Fig. 3C, the lifting body 16, whose upper part is in contact with the upper surface of the inner wall of the mounting table 13, is pushed up upward by the cylinder apparatus 17. In this state, since the lifting body 16 stands still in contact with the upper surface of the inner wall of the mounting table 13, the resultant force of the load applied to the lifting body 16 is balanced. For this reason, fluctuating load F4 (compressive load in the state shown in Fig. 3C) corresponding to a thrust force with which the cylinder apparatus 17 pushes up the lifting body 16 upward is applied to the measurement section (load cell) 2. In the state shown in Fig. 3C, the magnitude of fluctuating load F4 is about 50 N.

That is, in the state shown in Fig. 3C, supposing that the load measurement measured by the measurement section 2 is F, and the magnitude (absolute value) of the fluctuating load F4 is F4, the load measurement F is expressed by the following formula.

$$F = -F4$$

Therefore, during lifting-up of the substrate S as shown in Figs. 3A to 3C, the load measurement measured by the measurement section 2 will transit from tensile load to compressive load.

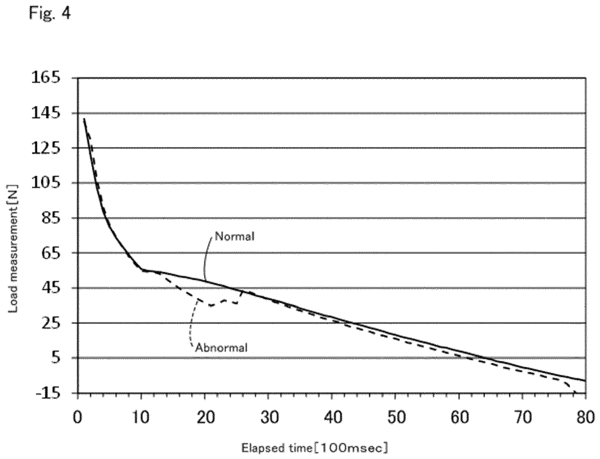

Fig. 4 is a diagram for showing an example of load measurements measured by the measurement section 2. The abscissa of Fig. 4 is elapsed time with reference to the starting time point of lifting-up of the substrate S, and the ordinate is the load measurement. A case in which the sign of the load measurement is positive means that load F4 or a total sum of F1 to F4 described by using Figs. 3A to 3C is tensile load. A case in which the sign of load measurement is negative means that load F4 or a total sum of load F1 to F4 is compressive load.

Fig. 4 shows temporal changes of the load measurement when lifting of the substrate S is normal, and temporal changes of the load measurement when lifting of the substrate S is abnormal due to detachment failure of the substrate S.

In the example shown in Fig. 4, a significant difference is recognized between the temporal changes of the load measurement when lifting of the substrate S is normal and the temporal changes of the load measurement when lifting of the substrate S is abnormal. For this reason, if an operator makes judgments by visually observing Fig. 4, it may be possible to detect lifting abnormality of the substrate S.

However, it is conceivable in reality that the difference in the temporal changes of load measurement according to whether or not lifting of the substrate S is normal is small. Further, even if lifting of the substrate S is normal, there is some variation in the temporal changes of the load measurement. For this reason, when attempt is made to simply compare the load measurement with a threshold, and automatically detect lifting abnormality from the magnitude thereof, it is conceivable that decision of the threshold becomes difficult, and the detection accuracy of lifting abnormality will deteriorate as well. Moreover, if the detection timing of lifting abnormality is delayed, there is a risk that the timing of stopping the operation of the lifting mechanism 4 is also delayed, and avoidance of transfer failure and damage of the substrate S is not in time.

Therefore, the abnormality detection apparatus 100 according to the first embodiment is configured such that lifting abnormality of the substrate S is detected by the detection section 3 including the learning model 31 generated by using machine learning, as described above. According to this, it is possible to quickly and accurately detect lifting abnormality of the substrate S.

Note that the lifting-up speed of the substrate S by the lifting mechanism 4 is preferably set to as slow speed as possible as long as there is no problem in the cycle time to process the substrate S. Particularly, when the cylinder apparatus 17 is an air cylinder apparatus, even if attempt is made to stop the operation of the lifting mechanism 4 immediately after detecting lifting abnormality, there will be unavoidable time delay until complete stopping. Therefore, by decreasing the lifting-up speed of the substrate S, it is possible to surely avoid transfer failure and damage of the substrate S due to lifting abnormality of the substrate S.

Further, to surely avoid transfer failure and damage of the substrate S due to lifting abnormality of the substrate S, lifting-up of the substrate S by the lifting mechanism 4 may be performed intermittently. That is, it is conceivable to temporarily stop the lifting-up of the substrate S after lifting up the substrate S for a fixed short distance, and determine whether lifting of the substrate S is normal or abnormal by using load measurements which have been measured until then. Then, it is also possible to adopt a mode in which when determined to be normal, the substrate S is lifted up again for a fixed short distance and the same operation is repeated.

Hereinafter, one example of the results of test of detecting lifting abnormality of the substrate S by the abnormality detection apparatus 100 according to the first embodiment will be described.

In the above described test, 16 data (data of No. 1 to No. 16) of temporal change of load measurement when lifting of the substrate S is normal, and 2 data (data of No. 17 and No. 18) of temporal change of load measurement when lifting of the substrate S is abnormal were measured at a sampling period of 100 msec respectively by the measurement section 2. Then data of No. 1 to No. 14 were used as the teaching data of the learning model 31. Note that machine learning was performed by sequentially inputting continuous five load measurements measured at each sampling period of 100 msec with a deviation of one sampling period, to the learning model 31 for any of data of No. 1 to No. 14.

Data of No. 15 to No. 18 were input for determination to the learning model 31 after learning as described above, and whether or not lifting abnormality of the substrate S had occurred was determined by the determination section 32. Note that, in this occasion, as at the time of learning, determination by the determination section 32 was performed at each sampling period by sequentially inputting continuous five load measurements measured at each sampling period of 100 msec with a deviation of one sampling period, for any of data of No. 15 to No. 18. Threshold Th set in the determination section 32 was 0.1.

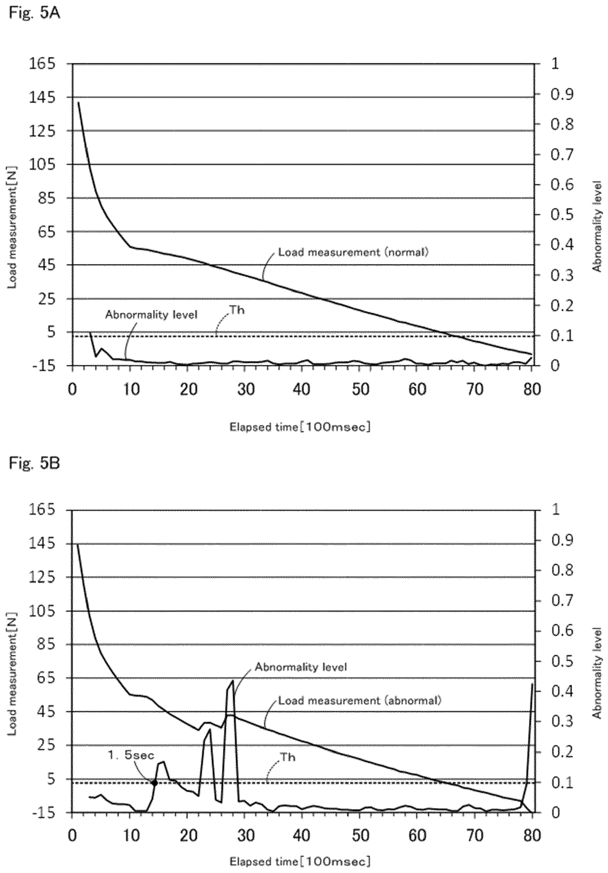

Figs. 5A and 5B are diagrams showing one example of test result described above by using the abnormality detection apparatus 100 according to the first embodiment. Fig. 5A shows load measurements and the abnormality level when data of No. 16 (normal) was used. Fig. 5B shows load measurements and the abnormality level when data of No. 18 (abnormal) was used. The abscissa of Figs. 5A and 5B is elapsed time with reference to the starting time point of lifting-up of the substrate S, and the ordinate is the load measurement and the abnormality level.

As shown in Fig. 5A, when lifting of the substrate S was normal, the value of the abnormality level output from the learning model 31 was small, and became less than the threshold Th = 0.1 at least after an elapse of 1 second from the start of lifting-up of the substrate S. As seen from Fig. 5A, since fluctuation (decrease) of the load measurement was large for about 1 second from the start of lifting-up of the substrate S, the abnormality level during this period was neglected in the real test, and determination was made by using the abnormality level after the elapse of 1 second. As a result of this, it was possible to determine that data of No. 16 shown in Fig. 5A was normal as in reality.

On the other hand, as shown in Fig. 5B, when lifting of the substrate S was abnormal, there was a time point at which the value of abnormality level output from the learning model 31 increased, firstly at the time point after the elapse of 1.5 seconds from the start of lifting-up of the substrate S, the abnormality level became not less than the threshold Th = 0.1. As a result of this, it was possible to determine that data of No. 18 shown in Fig. 5B was abnormal as in reality. Moreover, since it was possible to detect lifting abnormality at a time point when about 1.5 seconds elapsed from the start of lifting-up of the substrate S, it is possible to avoid transfer failure and damage of the substrate S by immediately stopping the operation of the lifting mechanism 4.

Table 1 is a table that summarizes results of the above described test. For data of No. 15 (normal) and data of No. 17 (abnormal), which are not shown in Figs. 5A and 5B, it was possible to obtain the same determination result as in reality and to quickly detect lifting abnormality.

[Table 1]

| Data | Real | Elapsed time until abnormality level becomes $\geq 0.1$ | Determination |
|---|---|---|---|
| No.15 | Normal | - | Normal |
| No.16 | Normal | - | Normal |
| No.17 | Abnormal | 1.4 sec | Abnormal |
| No.18 | Abnormal | 1.5 sec | Abnormal |

<Second embodiment>

The substrate processing system according to the second embodiment only differs from the first embodiment in that the learning model included in the detection section of the abnormality detection apparatus is a support vector machine.

Therefore, in the description below, drawings and symbols of each component used in the description of the substrate processing system according to the first embodiment are used as they are. Moreover, since the support vector machine used in the second embodiment is the same as the known content, detailed description thereof will be omitted.

In the second embodiment as well, the learning model 31 receives, as input, a plurality of load measurements continuously measured by the measurement section 2 during lifting-up of the substrate S by the lifting mechanism 4.

Specifically, a plurality of load measurements measured at each predetermined sampling period (for example, 100 msec) by the measurement section 2 are input to the learning model 31. However, in the second embodiment, unlike in the first embodiment in which a plurality of load measurements measured with a deviation of one sampling period are sequentially input, a plurality of load measurements measured in a predetermined period (for example, 1 to 2.5 sec from the start of lifting-up of the substrate S) are input to the learning model 31 at once.

At the time of learning of the learning model 31 of the second embodiment, as the input of the teaching data, a plurality (for example, a number corresponding to 1 to 2.5 sec from the start of lifting-up of the substrate S. 16 in the case in which the sampling period was 100 msec) of load measurements when lifting of the substrate S is normal are given, and as the output of the teaching data to be combined with the input, an indication of normal lifting of the substrate S (in the second embodiment as well, abnormality level = 0) is given so that machine learning is performed such that when the input is input to the learning model 31, the abnormality level = 0 is output from the learning model 31.

According to the above described machine learning, conceptually, for example, a coordinate space, in which the abscissa is elapsed time with reference to the starting time point of lifting-up of the substrate S and the ordinate is load measurement, is generated, and a region in which it is considered to be normal (normal region) is rendered in this coordinate space.

Then, at the time of detecting lifting abnormality of the substrate S (at the time of determining whether or not lifting abnormality has occurred), the same plurality (for example, a number corresponding to 1 to 2.5 sec from the start of lifting-up of the substrate S) of load measurements as in the time of learning are input to the learning model 31. Input load measurements are, conceptually, plotted in the coordinate space generated at the time of learning, and the learning model 31 will determine whether or not each plotted point is within the normal region. Then, the learning model 31 outputs the ratio of the number of points located outside the normal region to the number of all the points as an abnormality level.

The point that the determination section 32 determines that lifting of the substrate S is normal when the abnormality level is smaller than a preset threshold Th, and determines that lifting abnormality of the substrate S has occurred when the abnormality level is not less than the threshold Th is the same as in the first embodiment.

Hereinafter, an example of results of test to detect lifting abnormality of the substrate S by the abnormality detection apparatus 100 according to the second embodiment will be described.

In the above described test as well, like in the case of the test using the abnormality detection apparatus 100 according to the first embodiment, data of No. 1 to No. 18 were used. However, unlike the test of the first embodiment, in the test of the second embodiment, data of No. 1 to No. 8 were used as the input of the teaching data of the learning model 31. Note that, machine learning was performed by inputting a plurality (16) of load measurements measured in 1 to 2.5 sec from the start of lifting-up of the substrate S to the learning model 31 for any of data of No. 1 to No. 8. Note that, as the parameters of the support vector machine for use in the learning model 31 of the second embodiment, nu = 0.01, and gamma = 1 were set.

Data of No. 9 to No. 18 were input for determination to the learning model 31 after learning as described so far so that whether or not lifting abnormality of the substrate S had occurred was determined by the determination section 32. Note that in this occasion, as at the time of learning, for any of data of No. 9 to No. 18, a plurality of load measurements measured in 1 to 2.5 sec from the start of lifting-up of the substrate S were input to perform determination by the determination section 32. The threshold Th for setting in the determination section 32 was 0.1 as in the first embodiment.

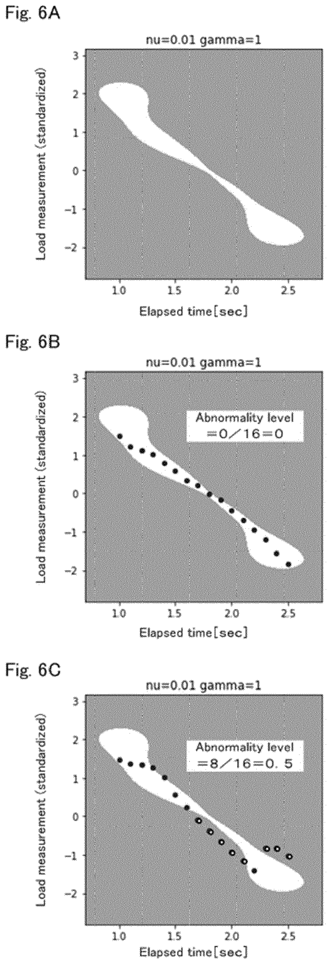

Figs. 6A, 6B, and 6C are diagrams for showing an example of test result by using the abnormality detection apparatus 100 according to the second embodiment. Fig. 6A shows a coordinate space and a normal region generated at the time of learning. Fig. 6B shows a diagram in which load measurements when data of No. 16 (normal) was used are plotted in the coordinate space of Fig. 6A. Fig. 6C shows a diagram in which load measurements when data of No. 18 (abnormal) was used are plotted in the coordinate space of Fig. 6A. The abscissa of Figs. 6A, 6B, and 6C is elapsed time with reference to the starting time point of lifting-up of the substrate S, and the ordinate is standardized load measurement. Z-score (standardized load measurement = (load measurement - average value of load measurements)/standard deviation of load measurements) was used for standardization.

As shown in Fig. 6A, a coordinate space, in which the abscissa is elapsed time with reference to the starting time point of lifting-up of the substrate S and the ordinate is standardized load measurements, is generated by machine learning in the learning model 31, and a normal region (region filled in white in Fig. 6A) is rendered in this coordinate space and stored.

As shown in Fig. 6B, when lifting of the substrate S was normal, each point (point of a black circle) at which a load measurement input to the learning model 31 was plotted in the coordinate space was located within a normal region. Therefore, 0 was output as the abnormality level from the learning model 31, which became smaller than the threshold Th = 0.1. As a result of this, it was possible to determine that data of No. 16 shown in Fig. 6B was normal as in reality.

On the other hand, as shown in Fig. 6C, when lifting of the substrate S was abnormal, among each point at which a load measurement input to the learning model 31 was plotted in the coordinate space, there were some points (points plotted by blank circles) which were located outside the normal region, and the ratio thereof was 0.5. Therefore, 0.5 was output as the abnormality level from the learning model 31, which was not less than the threshold Th = 0.1. As a result of this, it was possible to determine that data of No. 18 shown in Fig. 6C was abnormal as in reality. Further, since it is possible to detect lifting abnormality at a time point when about 2.5 sec has elapsed from the start of lifting-up of the substrate S, it is possible to avoid transfer failure and damage of the substrate S by immediately stopping the operation of the lifting mechanism 4.

Table 2 is a table that summarizes the results of the above described test. Even for the data of No. 9 to No. 15 (normal), and data of No. 17 (abnormal) which are not shown in Figs. 6A, 6B, and 6C, it will be possible to obtain the same determination result as in reality and to detect lifting abnormality at a time point when about 2.5 seconds elapses after the start of lifting-up of the substrate S.

[Table 2]

| Data | Real | Abnormality level | Determination |
|---|---|---|---|
| No.9 | Normal | 0 | Normal |
| No.10 | Normal | 0 | Normal |
| No.11 | Normal | 0 | Normal |
| No.12 | Normal | 0.0625 | Normal |
| No.13 | Normal | 0.0625 | Normal |
| No.14 | Normal | 0.0625 | Normal |
| No.15 | Normal | 0.0625 | Normal |
| No.16 | Normal | 0 | Normal |
| No.17 | Abnormal | 0.625 | Abnormal |
| No.18 | Abnormal | 0.5 | Abnormal |

As described so far, according to the abnormality detection apparatus 100 according to the first and second embodiments, it is possible to quickly and accurately detect lifting abnormality of the substrate S attributable to detachment failure of the substrate S from the electrostatic chuck 14.

Note that in the first and second embodiments, although description has been made on a mode in which a load cell is used as the measurement section 2 and the load cell is attached in an interposed manner to the piston rod 18 divided into an upper part and a lower part, the present invention will not be limited to this. For example, it is also possible to attach the load cell between the lifting body 16 and the piston rod 18, or to divide the lifting body 16 into an upper part and a lower part to attach the load cell therebetween.

Moreover, when an electric cylinder apparatus is used as the cylinder apparatus 17, it is also possible to adopt a mode in which the torque of a motor for driving the electric cylinder apparatus is measured, and this torque measurement is input to the learning model 31 as a parameter (a parameter having a correlation with the load applied to the lifting mechanism 4).

Moreover, in the first and second embodiments, although description has been made on a mode in which the measurement section 2 measures a parameter (load measurement) having a correlation with the load applied to the lifting mechanism 4 and inputs the parameter having a correlation with the load applied to the lifting mechanism 4 to the learning model 31, the present invention will not be limited to this.

For example, it is also possible to adopt a mode in which the measurement section 2 measures, in addition to a parameter having a correlation with the load applied to the lifting mechanism 4, at least one parameter of a parameter having a correlation with attraction force between the electrostatic chuck 14 and the substrate S and a parameter having a correlation with pressure inside the chamber 11, and the learning model 31 receives, as input, a plurality of measurements of the parameters continuously measured by the measurement section 2 during lifting-up of the substrate S by the lifting mechanism 4, and outputs a level of lifting abnormality of the substrate S. Because of this, it can be expected that compared with a case in which only a parameter having a correlation with the load applied to the lifting mechanism 4 is used, lifting abnormality of the substrate S can be detected with a further accuracy.

Note that as the measurement section 2 for measuring a parameter having a correlation with attraction force between the electrostatic chuck 14 and the substrate S, for example, an ammeter that measures leak current of the electrostatic chuck 14 as described in JP2006-100630A, a displacement gauge that measures a displacement amount of the substrate S, and a pressure gauge that measures the pressure of compressed air to the cylinder apparatus (air cylinder apparatus) 17 as described in JP2008-177464A can be named. Moreover, examples of the measurement section 2 for measuring a parameter having a correlation with the pressure inside the chamber 11 include a vacuum gauge attached to the chamber 11.

Further, in the first embodiment, a mode in which the learning model 31 is generated by machine learning with use of the k-nearest neighbor algorithm is exemplified, and in the second embodiment, a mode in which the learning model 31 is a support vector machine is exemplified; however, the present invention will not be limited to these. For example, various configurations may be adopted as long as they are learning models that can be generated by using machine learning such as neural networks (including CNN (Convolution Neural Network) and RNN (Recurrent neural network)).

Moreover, in the first and second embodiments, a mode in which lifting abnormality of the substrate S attributable to detachment failure of the substrate S is detected has been described; however, the present invention will not be limited to this. For example, it is also possible to detect abnormality in which the substrate S interferes with a member constituting the substrate processing apparatus 10 due to misalignment, etc. in the process of lifting up the substrate S by the lifting mechanism included in a transfer robot which operates in the substrate processing apparatus 10.

Further, in the first and second embodiments, a case in which the substrate processing apparatus 10 is a plasma processing apparatus has been exemplified; however, the present invention will not be limited to this. It can be applied various substrate processing apparatuses as long as they include lifting mechanism for lifting the substrate S. The invention is as defined in the appended claims.

[Reference Signs List]

| | |
|---|---|
| 10 | Substrate processing apparatus |
| 11 | Chamber |
| 13 | Mounting table |
| 14 | Electrostatic chuck |
| 15 | Lift pin |
| 16 | Lifting body |
| 17 | Cylinder apparatus |
| 18 | Piston rod |
| 2 | Measurement section |
| 3 | Detection section |
| 4 | Lifting mechanism |
| 31 | Learning model |
| 32 | Determination section |
| 100 | Abnormality detection apparatus |
| S | Substrate |

**Claims**

1. An abnormality detection apparatus for detecting lifting abnormality of a substrate (S) in a substrate processing apparatus (10) including a lifting mechanism (4) for lifting the substrate (S), comprising:

   a measurement section (2) configured to measure a parameter having a correlation with load applied to the lifting mechanism (4); and
   a detection section (3) configured to detect lifting abnormality of the substrate (S), further **characterised in that** the detection section (3) includes a learning model (31) generated by using machine learning, wherein the learning model (31) receives, as input, a plurality of measurements of the parameter continuously measured by the measurement section (2) during lifting-up of the substrate (S) by the lifting mechanism (4), and outputs a level of lifting abnormality of the substrate (S).

2. The abnormality detection apparatus according to claim 1, wherein the learning model (31) is generated by using machine learning such that in the case of receipt of a plurality of measurements of the parameter taken when lifting of the substrate (S) is normal as an input of teaching data, the learning model (31) outputs an indication of normal lifting of the substrate (S).

3. The abnormality detection apparatus according to claim 1 or 2, wherein

the substrate processing apparatus (10) includes an electrostatic chuck (14) for electrostatically attracting the substrate (S) when processing the substrate (S), and the detection section (3) detects lifting abnormality of the substrate (S) attributable to detachment failure of the substrate (S) based on a plurality of measurements of the parameter continuously measured by the measurement section (2) during lifting-up of the substrate (S) by the lifting mechanism (4) after stopping electrostatic attraction of the substrate (S) by the electrostatic chuck (14).

4.  The abnormality detection apparatus according to any of claims 1 to 3, wherein

    the lifting mechanism (4) comprises a lift pin (15) which is brought into contact with a rear face of the substrate (S) and lifts the substrate (S), and a cylinder apparatus (17) which is connected to the lift pin (15) and lifts the lift pin (15), and wherein
    the measurement section (2) is a load cell which is attached to a piston rod (18) of the cylinder apparatus (17) and measures load applied to the piston rod (18).

5.  The abnormality detection apparatus according to any of claims 1 to 4, wherein
    the learning model (31) is generated by using machine learning based on a k-nearest neighbor algorithm.

6.  The abnormality detection apparatus according to any of claims 1 to 5, wherein

    the substrate processing apparatus (10) includes a chamber (11) which is under a vacuum environment when processing the substrate (S), and an electrostatic chuck (14) for electrostatically attracting the substrate (S) when processing the substrate (S),
    the measurement section (2) measures, in addition to the parameter having a correlation with load applied to the lifting mechanism (4), at least one parameter of a parameter having a correlation with attraction force between the electrostatic chuck (14) and the substrate (S) and a parameter having a correlation with pressure inside the chamber (11), and
    the learning model (31) receives, as input, a plurality of measurements of the parameters continuously measured by the measurement section (2) during lifting-up of the substrate (S) by the lifting mechanism (4), and outputs a level of lifting abnormality of the substrate (S).

7.  The abnormality detection apparatus according to any of claims 1 to 6, wherein the detection section (3) includes an input section configured to input presence or absence of lifting abnormality of the substrate (S), and stores the presence or absence of lifting abnormality of the substrate (S) input from the input section, in association with a plurality of measurements of the parameter continuously measured by the measurement section (2), and detection result of lifting abnormality of the substrate (S) by the detection section (3).

8.  A substrate processing system, comprising

    a substrate processing apparatus (10) including a lifting mechanism (4) for lifting a substrate (S), and
    the abnormality detection apparatus (100) according to any of claims 1 to 7.

9.  An abnormality detection method for detecting lifting abnormality of a substrate (S) in a substrate processing apparatus (10) including a lifting mechanism (4) for lifting the substrate, comprising:

    a measurement step of measuring a parameter having a correlation with load applied to the lifting mechanism (4); and
    a detection step of detecting lifting abnormality of the substrate (S), wherein
    in the detection step, by using a learning model (31) generated by using machine learning, a plurality of measurements of the parameter continuously measured in the measurement step during lifting-up of the substrate (S) by the lifting mechanism (4) are input to the learning model (31), and a level of lifting abnormality of the substrate (S) is output from the learning model (31).

10. A program for causing a detection section (3) including the learning model (31) to execute the detection step included in the abnormality detection method according to claim 9.

11. A generation method of a learning model, wherein

    the learning model (31) receives, as input, a plurality of measurements of a parameter having a correlation with load applied to a lifting mechanism (4) included in a substrate processing apparatus (10), the plurality of measurements of the parameter being continuously measured during lifting-up of a substrate (S) by the lifting mechanism (4), and the learning model (31) outputs a level of lifting abnormality of the substrate (S), and wherein the learning model (31) is generated by using machine learning such that in the case of receipt of a plurality of measurements of the parameter taken when lifting of the substrate (S) is normal as an input of teaching data, the learning model (31) outputs an indication of normal lifting of the substrate (S).

**Patentansprüche**

1. Vorrichtung für Erfassung von Abnormalität, mit der eine Abnormalität bei Anheben eines Substrats (S) in einer Substrat-Verarbeitungsvorrichtung (10) erfasst wird, die einen Anhebe-Mechanismus (4) zum Anheben des Substrats (S) enthält, wobei sie umfasst:

   einen Messungs-Teilabschnitt (2), der zum Messen eines Parameters ausgeführt ist, der eine Korrelation mit auf den Anhebe-Mechanismus (4) wirkender Last aufweist; sowie einen Erfassungs-Teilabschnitt (3), der so ausgeführt ist, dass er Abnormalität bei Anheben des Substrats (S) erfasst, des Weiteren
   **dadurch gekennzeichnet, dass**
   der Erfassungs-Teilabschnitt (3) ein Lernmodell (31) enthält, das unter Einsatz von maschinellem Lernen generiert wird, wobei das Lernmodell (31) als Eingang eine Vielzahl von Messungen des Parameters empfängt, der kontinuierlich von dem Messungs-Teilabschnitt (2) bei Anheben des Substrats (S) durch den Anhebe-Mechanismus (4) gemessen wird, und einen Grad von Abnormalität bei Anheben des Substrats (S) ausgibt.

2. Vorrichtung für Erfassung von Abnormalität nach Anspruch 1, wobei
   das Lernmodell (31) unter Einsatz von maschinellem Lernens so generiert wird, dass bei Empfang einer Vielzahl von Messungen des Parameters, die bei normalem Anheben des Substrats (S) vorgenommen werden, als eine Eingabe von Lehrdaten das Lernmodell (31) eine Anzeige von normalem Anheben des Substrats (S) ausgibt.

3. Vorrichtung für Erfassung von Abnormalität nach Anspruch 1 oder 2, wobei

   die Substrat-Verarbeitungsvorrichtung (10) eine elektrostatische Aufspannvorrichtung (14) enthält, mit der das Substrat (S) beim Verarbeiten des Substrats (S) elektrostatisch angezogen wird, und
   der Erfassungs-Teilabschnitt (3) auf Basis einer Vielzahl von Messungen des Parameters, der beim Anheben des Substrats (S) durch den Anhebe-Mechanismus (4) kontinuierlich gemessen wird, Abnormalität bei Anheben des Substrats (S) erfasst, die auf fehlgeschlagene Ablösung des Substrats (S) nach Unterbrechung elektrostatischer Anziehung des Substrats (S) durch die elektrostatische Aufspannvorrichtung (14) zurückzuführen ist.

4. Vorrichtung für Erfassung von Abnormalität nach einem der Ansprüche 1 bis 3, wobei der Anhebe-Mechanismus (4) einen Anhebe-Stift (15), der in Kontakt mit einer Rückseite des Substrats (S) gebracht wird und das Substrat (S) anhebt, sowie eine Zylindervorrichtung (17) umfasst, die mit dem Anhebe-Stift (15) verbunden ist und den Anhebe-Stift (15) anhebt, und
   der Messungs-Teilabschnitt (2) eine Kraftmesszelle ist, die an einer Kolbenstange (18) der Zylindervorrichtung (17) angebracht ist und auf die Kolbenstange (18) wirkende Last misst.

5. Vorrichtung für Erfassung von Abnormalität nach einem der Ansprüche 1 bis 4, wobei das Lernmodell (31) unter Einsatz von maschinellem Lernen auf Basis eines Nächster-Nachbar-Algorithmus (k-nearest neighbor algorithm) generiert wird.

6. Vorrichtung für Erfassung von Abnormalität nach einem der Ansprüche 1 bis 5, wobei die Substrat-Verarbeitungsvorrichtung (10) eine Kammer (11), die sich beim Verarbeiten des Substrats (S) in einer Vakuumumgebung befindet, sowie eine elektrostatische Aufspannvorrichtung (14) zum elektrostatischen Anziehen des Substrats (S) beim Verarbeiten des Substrats (S) einschließt,

   der Messungs-Teilabschnitt (2) zusätzlich zu dem Parameter, der eine Korrelation mit auf den Anhebe-Mechanismus (4) wirkender Last aufweist, wenigstens einen Parameter, der eine Korrelation mit der Anziehungskraft zwischen der elektrostatischen Aufspannvorrichtung (14) und dem Substrat (S) aufweist, sowie einen Parameter misst, der eine Korrelation mit Druck im Inneren der Kammer (11) aufweist, und
   das Lernmodell (31) als Eingang eine Vielzahl von Messungen der Parameter empfängt, die kontinuierlich von dem Messungs-Teilabschnitt (2) beim Anheben des Substrats (S) durch den Anhebe-Mechanismus (4) gemessen werden, und einen Grad von Abnormalität bei Anheben des Substrats (S) ausgibt.

7. Vorrichtung für Erfassung von Abnormalität nach einem der Ansprüche 1 bis 6, wobei der Erfassungs-Teilabschnitt (3) einen Eingabe-Teilabschnitt enthält, der zum Eingeben von Vorhandensein oder Nichtvorhandensein von Abnormalität bei Anheben des Substrats (S) ausgeführt ist, und das Vorhandensein oder Nichtvorhandensein von Abnormalität bei Anheben des Substrats (S), das über den Eingabe-Teilabschnitt eingegeben wird, in Verbindung mit einer Vielzahl von Messungen des Parameters, der kontinuierlich von dem Messungs-Teilabschnitt (2) gemessen wird, sowie des Ergebnisses von Erfassung von Abnormalität bei Anheben des Substrats (S) durch den Erfassungs-Teilabschnitt (3) speichert.

8. Substrat-Verarbeitungssystem, das umfasst:

eine Substrat-Verarbeitungsvorrichtung (10), die einen Anhebe-Mechanismus (4) zum Anheben eines Substrats (S) enthält, sowie
die Vorrichtung (100) für Erfassung von Abnormalität nach einem der Ansprüche 1 bis 7.

9. Verfahren für Erfassung von Abnormalität, mit dem Abnormalität bei Anheben eines Substrats (S) in einer Substrat-Verarbeitungsvorrichtung (10) erfasst wird, die einen Anhebe-Mechanismus (4) zum Anheben des Substrats enthält, wobei es umfasst:

einen Messungs-Schritt zum Messen eines Parameters, der eine Korrelation mit auf den Anhebe-Mechanismus (4) wirkender Last aufweist; sowie
einen Erfassungs-Schritt zum Erfassen von Abnormalität bei Anheben des Substrats (S), wobei
in dem Erfassungs-Schritt unter Einsatz eines Lernmodells (31), das unter Einsatz von maschinellem Lernen generiert wird, eine Vielzahl von Messungen des Parameters, der kontinuierlich in dem Messungs-Schritt bei Anheben des Substrats (S) durch den Anhebe-Mechanismus (4) gemessen wird, in das Lernmodell (31) eingegeben wird, und ein Grad von Abnormalität bei Anheben des Substrats (S) von dem Lernmodell (31) ausgegeben wird.

10. Programm, mit dem ein Erfassungs-Teilabschnitt (3), der das Lernmodell (31) enthält, veranlasst wird, den Erfassungs-Schritt auszuführen, der in dem Verfahren für Erfassung von Abnormalität nach Anspruch 9 eingeschlossen ist.

11. Verfahren für Generierung eines Lernmodells, wobei

das Lernmodell (31) als Eingabe eine Vielzahl von Messungen eines Parameters empfängt, der eine Korrelation mit einer auf einen Anhebe-Mechanismus (4) wirkenden Last aufweist, der in einer Substrat-Verarbeitungsvorrichtung (10) enthalten ist, wobei die Vielzahl von Messungen des Parameters kontinuierlich bei Anheben eines Substrats (S) durch den Anhebe-Mechanismus (4) gemessen wird, und das Lernmodell (31) einen Grad von Abnormalität bei Anheben des Substrats (S) ausgibt, und
das Lernmodell (31) unter Einsatz von maschinellem Lernen so generiert wird, dass bei Empfang einer Vielzahl von Messungen des Parameters, die bei normalem Anheben des Substrats (S) vorgenommen werden, als eine Eingabe von Lehrdaten das Lernmodell (31) eine Anzeige von normalem Anheben des Substrats (S) ausgibt.

## Revendications

1. Appareil de détection d'anomalie pour détecter une anomalie de levage d'un substrat (S) dans un appareil de traitement de substrat (10) incluant un mécanisme de levage (4) pour lever le substrat (S), comprenant :

une section de mesure (2) configurée pour mesurer un paramètre présentant une corrélation avec une charge appliquée sur le mécanisme de levage (4) ; et
une section de détection (3) configurée pour détecter une anomalie de levage du substrat (S),
**caractérisé en outre en ce que**
la section de détection (3) inclut un modèle d'apprentissage (31) généré en utilisant un apprentissage automatique, dans lequel le modèle d'apprentissage (31) reçoit, en tant qu'entrée, une pluralité de mesures du paramètre mesuré en continu par la section de mesure (2) pendant le levage du substrat (S) par le mécanisme de levage (4) et émet en sortie un niveau d'anomalie de levage du substrat (S).

**2.** Appareil de détection d'anomalie selon la revendication 1, dans lequel
le modèle d'apprentissage (31) est généré en utilisant un apprentissage automatique de sorte que, dans le cas de la réception d'une pluralité de mesures du paramètre prises lorsque le levage du substrat (S) est normal en tant qu'entrée de données d'enseignement, le modèle d'apprentissage (31) émet en sortie une indication de levage normal du substrat (S).

**3.** Appareil de détection d'anomalie selon la revendication 1 ou 2, dans lequel
l'appareil de traitement de substrat (10) inclut un mandrin électrostatique (14) pour attirer électrostatiquement le substrat (S) lors du traitement du substrat (S), et la section de détection (3) détecte une anomalie de levage du substrat (S) attribuable à un échec de détachement du substrat (S) sur la base d'une pluralité de mesures du paramètre mesuré en continu par la section de mesure (2) pendant le levage du substrat (S) par le mécanisme de levage (4) après l'arrêt de l'attraction électrostatique du substrat (S) par le mandrin électrostatique (14).

**4.** Appareil de détection d'anomalie selon l'une quelconque des revendications 1 à 3, dans lequel

le mécanisme de levage (4) comprend une broche de levage (15) qui est amenée en contact avec une face arrière du substrat (S) et qui lève le substrat (S), et un appareil de cylindre (17) qui est connecté à la broche de levage (15) et qui lève la broche de levage (15), et dans lequel
la section de mesure (2) est une cellule de mesure qui est liée à une tige de piston (18) de l'appareil de cylindre (17) et qui mesure une charge appliquée sur la tige de piston (18).

**5.** Appareil de détection d'anomalie selon l'une quelconque des revendications 1 à 4, dans lequel
le modèle d'apprentissage (31) est généré en utilisant un apprentissage automatique basé sur un algorithme des k plus proches voisins.

**6.** Appareil de détection d'anomalie selon l'une quelconque des revendications 1 à 5, dans lequel

l'appareil de traitement de substrat (10) inclut une chambre (11) qui est au-dessous d'un environnement sous vide lors du traitement du substrat (S) et un mandrin électrostatique (14) pour attirer électrostatiquement le substrat (S) lors du traitement du substrat (S),
la section de mesure (2) mesure, en plus du paramètre présentant une corrélation avec une charge appliquée sur le mécanisme de levage (4), au moins un paramètre parmi un paramètre présentant une corrélation avec une force d'attraction entre le mandrin électrostatique (14) et le substrat (S) et un paramètre présentant une corrélation avec une pression à l'intérieur de la chambre (11), et
le modèle d'apprentissage (31) reçoit, en tant qu'entrée, une pluralité de mesures des paramètres mesurés en continu par la section de mesure (2) pendant le levage du substrat (S) par le mécanisme de levage (4) et émet en sortie un niveau d'anomalie de levage du substrat (S).

**7.** Appareil de détection d'anomalie selon l'une quelconque des revendications 1 à 6, dans lequel
la section de détection (3) inclut une section d'entrée configurée pour recevoir en entrée la présence ou l'absence d'anomalie de levage du substrat (S), et stocke la présence ou l'absence d'anomalie de levage du substrat (S) reçue en entrée depuis la section d'entrée, en association avec une pluralité de mesures du paramètre mesuré en continu par la section de mesure (2), et un résultat de détection d'anomalie de levage du substrat (S) obtenu par la section de détection (3).

**8.** Système de traitement de substrat, comprenant

un appareil de traitement de substrat (10) incluant un mécanisme de levage (4) pour lever un substrat (S), et l'appareil de détection d'anomalie (100) selon l'une quelconque des revendications 1 à 7.

**9.** Procédé de détection d'anomalie pour détecter une anomalie de levage d'un substrat (S) dans un appareil de traitement de substrat (10) incluant un mécanisme de levage (4) pour lever le substrat, comprenant :

une étape de mesure pour mesurer un paramètre présentant une corrélation avec une charge appliquée sur le mécanisme de levage (4) ; et
une étape de détection pour détecter une anomalie de levage du substrat (S), dans lequel
au niveau de l'étape de détection, en utilisant un modèle d'apprentissage (31) généré en utilisant un apprentissage automatique, une pluralité de mesures du paramètre mesuré en continu au niveau de l'étape de mesure pendant le levage du substrat (S) par le mécanisme de levage (4) sont entrées sur le modèle d'apprentissage (31), et un niveau d'anomalie de levage du substrat (S) est émis en sortie depuis le modèle d'apprentissage (31).

10. Programme pour forcer une section de détection (3) incluant le modèle d'apprentissage (31) à exécuter l'étape de détection incluse dans le procédé de détection d'anomalie selon la revendication 9.

11. Procédé de génération d'un modèle d'apprentissage, dans lequel

le modèle d'apprentissage (31) reçoit, en tant qu'entrée, une pluralité de mesures d'un paramètre présentant une corrélation avec une charge appliquée sur un mécanisme de levage (4) inclus dans un appareil de traitement de substrat (10), la pluralité de mesures se rapportant au paramètre mesuré en continu pendant le levage d'un substrat (S) par le mécanisme de levage (4), et le modèle d'apprentissage (31) émet en sortie un niveau d'anomalie de levage du substrat (S), et dans lequel
le modèle d'apprentissage (31) est généré en utilisant un apprentissage automatique de sorte que, dans le cas de la réception d'une pluralité de mesures du paramètre prises lorsque le levage du substrat (S) est normal en tant qu'entrée de données d'enseignement, le modèle d'apprentissage (31) émet en sortie une indication de levage normal du substrat (S).

Fig. 1A

Fig. 1B

Fig. 2

Fig. 3A

Fig. 3B

Fig. 3C

$F = F4$

$F = -F1+F2-F3-F4$

$F = -F4$

Fig. 4

Fig. 5A

Fig. 5B

Fig. 6A

Fig. 6B

Fig. 6C

## REFERENCES CITED IN THE DESCRIPTION

### Patent documents cited in the description

- US 2008285203 A
- JP 2010278271 A
- JP 2008277706 A
- JP 2006100630 A
- JP 2008177464 A